# EUROPEAN PATENT SPECIFICATION

(11) **EP 0 357 333 B1**
(45) Date of publication and mention of the grant of the patent: **28.12.1994**
(21) Application number: 89308565.4
(22) Date of filing: 24.08.1989
(51) Int. Cl.: G11C 16/06

(54) **Sealed charge storage structure**
Versiegelte Ladungsspeicheranordnung
Structure de stockage de charge scellée

(30) Priority: 01.09.1988 US 240830
(43) Date of publication of application: 07.03.1990
(73) Proprietor: ATMEL CORPORATION, San Jose California 95131 (US)
(72) Inventor: Wu, Tsung-Ching, Santa Clara California 95128 (US); Hu, James Cheng, Santa Clara California 95070 (US); Huang, John Y., Alameda California 94539 (US)
(74) Representative: Purvis, William Michael Cameron

(56) References cited:
- EP-A- 0 227 549
- JP-A-62 092 376
- US-A- 4 519 050
- US-A- 4 530 074
- US-A- 4 758 869

## Description

The invention relates to charge storage constructions, and in particular to nonvolatile, semiconductor memory devices employing floating gate memory cells as indicated in the preamble of claim 1 and e.g. known from US-A-4,805,138.

In erasable programmable read-only memory (EPROM) devices, it is often desirable to have some memory cells completely sealed from ultraviolet light or other radiant energy so that these cells can store charge in their floating gates permanently. These cells are programmable read-only devices, i.e. non-erasable. This is usually accomplished with a layer of ultraviolet blocking material, such as metal, silicon or polysilicon, covering a memory cell to prevent the floating gate of the memory cell from being exposed to ultraviolet light. Like other memory cells on the EPROM device, the shielded memory cells are programmable by injecting charges into their floating gates. However, unlike the unshielded EPROM cells, the shielded memory cells should not be erasable when the device is flood exposed to ultraviolet light. The shielded memory cells operate, in effect, like a fusible PROM. Patent Specifications US-A-4,519,050 and US-A-4,530,074 to Folmsbee disclose EPROM devices having a radiative shield covering some memory cells, thereby inhibiting them from being erased and thereby enabling them to be permanently programmed. In an article entitled "An 80ns Address-Date Multiplex IMb CMOS EPROM", 1987 IEEE Int'l Solid State Circuits Conference, p. 70-71, M. Yoshida et al. describe, in Figure 5, an EPROM with a sub-surface contact to a cover material. However, the cover has an opening for emergence of a control gate.

In order to be useful, each memory cell in an EPROM, whether shielded or not, needs three connections, one each for source, drain and control gate, to the rest of the memory circuit. Otherwise, the cell would be inaccessible. For the shielded memory cells, these three connections typically require openings in the shield for the poly or other conductive leads, such as diffused or metal leads. Thus the shielded memory cells will have gaps or light paths where ultraviolet light may leak in and possibly cause accidental erasure of information stored as charges on the floating gates. Even where the openings through the shield are isolated from the cell area by a zig-zag shaped shield so as to provide a tortuous path for attenuating light, under flood exposure to ultraviolet light it is still possible that some shielded memory cells may be accidentally erased.

According to the invention there is provided a sealed memory cell as indicated in claim 1.

Advantageously a thin gate oxide layer is disposed over the substrate between the source and drain implants.

Preferably the source and said drain are implants spaced apart in a memory cell area of the substrate.

Advantageously at least one of the plurality of memory cells formed in memory cell areas of the chip is an EPROM.

Preferably the connecting means further includes an electrically conductive layer disposed over and contacting the source, the conductive layer also contacting a side of the cover, the cover also being electrically conductive.

The source and the drain can be defined by arsenic N+ implants.

A ring implant can be disposed in the substrate beneath the sides of the cover, the channels crossing under the ring implant in crossing regions, the ring implant being a P+ implant at least in the crossing regions.

Such shielded memory cells in an EPROM device can be totally sealed from ultraviolet light, while still providing the necessary source, drain and gate connections to external circuitry.

Thus the memory cell is totally surrounded at the top and the sides by a conductive material cover, i.e. metal, silicon or polysilicon, and thus completely sealed from ultraviolet light, while access to the drain and the floating gate is provided by a conductive channel, such as an N+ diffusion or a buried N+ implant, in the substrate crossing underneath the cover. Access to the source is provided by direct contact with the conductive cover. Because of this undercross diffusion or implant there is no need for openings in the cover or shield to allow passage of conductive lines from the source, drain and gate terminals, since all terminals are effectively moved to outside the cover. The memory cell is completely sealed and no ultraviolet light can leak in to the floating gate.

An additional advantage of using a diffusion or implant to provide access to the floating gate, is that the memory cell does not require a double polysilicon stacking arrangement for the gate. Only a single polysilicon deposition is needed to form the memory cell. Essentially this arrangement includes a first electrode, such as a control gate, defined within the semiconductor substrate, and an electrically floating second electrode disposed above the substrate in electron injection communication with the first electrode, whereby the second electrode, such as the above-noted floating gate, stores accumulated charges. Means may be defined within the substrate to contact the first electrode with a terminal outside of a radiation shielding cover enclosing the floating second electrode or with the cover itself, so that the charge in the floating electrode may be sensed by external circuitry. Additional electrodes, such as a drain and source, may also be provided, or not, depending on the particular storage structure.

The invention is diagrammatically illustrated by way of example in the accompanying drawings, in which:-
Figure 1 is a top plan of a sealed memory cell according to the invention;
Figure 2 is a side section taken on line 2-2 in Figure 1, and illustrating an external gate connection for the memory cell;
Figure 3 is a side section taken on line 3-3 in Figure 1, and illustrating an external drain connection for the memory cell; and
Figure 4 is a top plan of an alternate floating gate configuration for use with a memory cell of the invention.

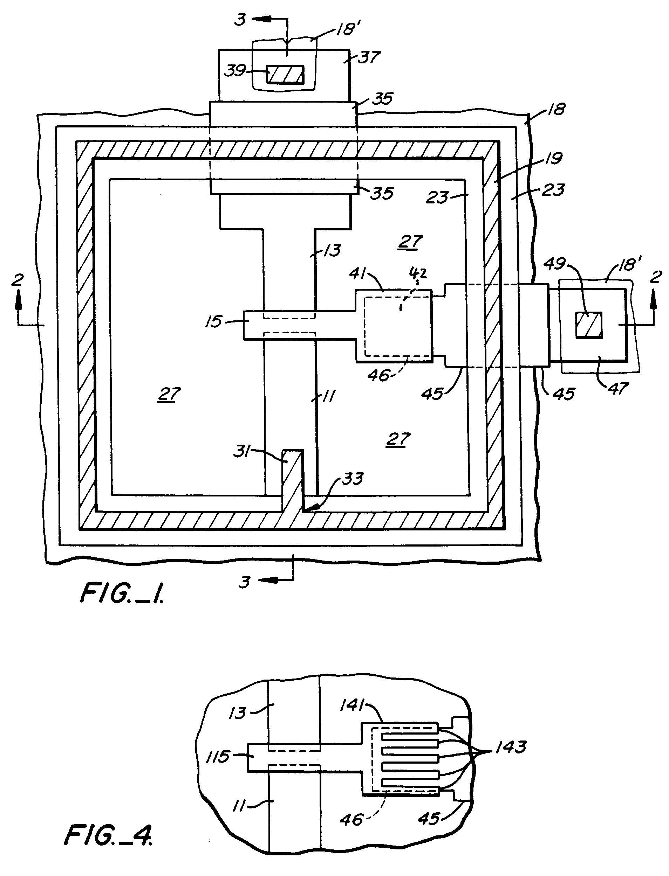

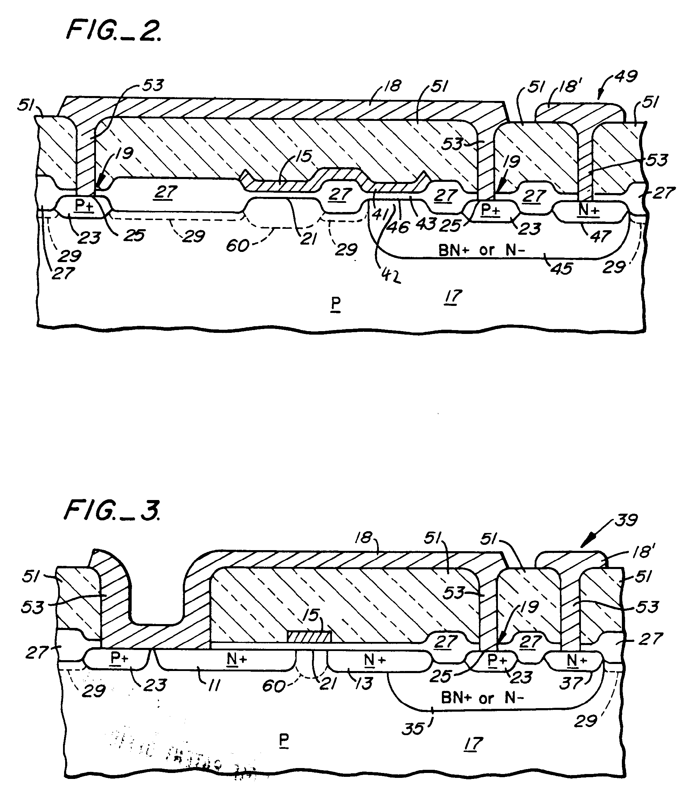

With reference to Figures 1 to 3, a sealed memory cell embodied in an EPROM device, comprises a source 11, a drain 13 and a floating gate 15 disposed on a semiconductor material substrate 17. The floating gate 15 is shielded from ultraviolet light and other radiant energy by a cover 18 completely surrounding and sealing in the memory cell at the top and the sides. The semiconductor material, typically silicon, of the substrate 17 blocks ultraviolet light and other radiant energy incident at the bottom of the EPROM device.

Typically, the substrate 17 is composed of a p-type (100)-oriented monocrystalline silicon material doped to a level sufficient to provide a resistivity in a range from 5 to 50 ohm-cm. The entire EPROM device, including the sealed memory cells, is made by a conventional CMOS N-well process with N-channel memory cells. The remainder of the EPROM device, including unsealed EPROM cells, N- and P-channel transistors and associated conductive circuitry, is not shown since it is completely conventional in both structure and fabrication.

The source 11 and the drain 13 areas typically comprise arsenic N+ diffusion implants. The arsenic implantation dose is about 4 -6 x 10¹⁵/cm². The floating gate 15 typically comprises a polysilicon layer with a thickness in a range of 2000 - 2600 Å (10 Å = 1 nm) and preferably less than 2400 Å thick. The floating gate polysilicon is formed over a gate oxide layer 21 about 300 - 350 Å thick and is doped with phosphorus to a concentration of about 10²⁰ - 10²¹/cm³ so as to reduce its sheet resistance to 15 - 40 ohm. As is conventional, a boron implant may be provided in the memory cell areas to adjust threshold.

The radiation shield or cover 18 is typically composed of a conductive material such as aluminium or another metal. Alternatively, silicon substrate material polysilicon which has been p-type doped, such as with boron, may be used. The conductive cover 18 contacts a P+ diffusion ring 23 and the source 11 by contact regions 19 and 31. The contact region 19 is a ring shaped contact to the P+ diffusion ring 23 only. The radiation cover 18 is oversize relative to the outer perimeter of the contact region 19. The ring 23 completely surrounds the memory cell. The ring 23 can also be an N+ ring except in areas discussed below where there is a buried N+ or N-well crossing. Those cross areas of the ring 23 must be p-type. A 0.8 - 1.2 micron thick field oxide layer 27 with field boron implant channel stops 29 is provided around memory cell elements wherever electrical isolation is needed.

In order to provide electrical access to the source 11, the drain 13 and the floating gate 15 without providing openings in the cover 18, electrically conductive channels are provided which cross under the P+ ring 23. Access to the source 11 may be achieved via the direct contact region 31 with the cover 18. It may also be achieved with an N-well, buried N+ implant or buried N+ layer, similar to a layer 35 in the drain connection, described below.

Access to the drain 13 is provided by an N-well, buried N+ implant or the buried N+ layer 35 extending from the N+ drain implant 13 underneath the P+ ring 23 and the cover 18 to an N+ drain connection diffusion implant 37 on the outside of the memory cell, i.e. outside the P+ ring 23. A metal terminal 18 fills up a contact hole 39 and makes contact with the drain connection implant 37.

Access to the floating gate 15 is also provided by means of a conductive channel extending under the P+ ring 23 and the cover 18. The floating gate 15 is a piece of polysilicon with an elongate portion extending over the gate oxide layer 21 above the gap or channel between the source 11 and the drain 13 and a larger coupling portion 41 lying over a surface coupling area 46 of the buried N+ layer, buried N+ implant or N-well 45. A channel implant 60 under the gate oxide layer 21 is used to adjust the threshold voltage of the memory cell. The thick field oxide layer 27 with the channel stop implant 29 separates the actual gate area between the source 11 and the drain 13 and the coupling area 46. The coupling portion 41 of the floating gate polysilicon may be a square or rectangular piece as shown in Figure 1 or may be a fork-like coupling portion 141, as in Figure 4, with several finger projections 143. The shape of the coupling portion 41 or 141 may be varied so as to vary the capacitance of the coupling. A thin oxide layer 43, typically 300 - 350 Å thick is disposed between the coupling portion 41 or 141 of the floating gate 15 and the control electrode (42) at the surface area 46 of the buried N+ layer, the buried N+ implant or the N-well 45, which in turn extends under the P+ ring 23 and the cover 18 to an N+ control gate connection diffusion implant 47 outside of the memory cell of the P+ ring 23. A metal terminal 18′ fills up a contact opening 49 and makes contact with the control gate connection implant 47.

The EPROM device structures, such as the source 11, the drain 13, the drain connection 37, the floating gate 15 and the control gate connection implant 47 of the sealed memory cells, are covered with boron/phosphorus-doped silicon glass (BPSG) 51 and contact holes 53 are opened in the glass for the necessary conductive connections, such as the sides of the cover 19 and the metal drain and gate connections 39 and 49. Phosphorus-doped silica glass (PSG) may also be used. The top of the cover 18 is deposited on top of the BPSG 51. Prior to this deposition, the EPROM device may be exposed to ultraviolet light to remove any residual charges stored in the floating gate 15 during fabrication. Other conductive lines, not shown, connect to the source, and the drain and gate connections 18, 39 and 49, and form part of the overall EPROM circuit. More than one layer of conductive lines separated by an intermetal insulative layer may be necessary.

The sealed memory cell is programmed by injecting charges into the floating gate 15 by way of electron injection across the thin oxide layer 21 or by hot electron injection through the oxide layer 21. Typically, the source 11 is placed at ground potential via the cover 18, the drain 13 is placed at 12 volts potential or higher via the drain connection 39, and the control gate, represented by the control gate connection 47, the buried N+ implant 45 and the surface area 46, is placed at 12 volts potential or higher via the gate connection 49. The control gate capacitively couples to the floating gate 15 via the surface area 46, the thin oxide layer 43 and the coupling area 41 or 141. Though in structure it is quite different, in normal operation the memory cell described is equivalent to the regular EPROM cell with stacked gates, and is read in the same manner. The only operational difference is that the sealed memory cell cannot be erased. The buried channels enable electrical communication with the drain, the source and the gate elements of the memory cell without the previously necessary openings in the cover 18. Thus, ultraviolet light cannot leak into the memory cell and cause accidental erasure.

While the invention has been described with respect to memory cells, other charge storage structures might need to be shielded from light or other radiation. In such a situation, the electrode contact construction of the invention may be employed. The shield material would be appropriate for blocking the undesired radiation.

## Claims

1. A sealed memory cell in a nonvolatile memory chip, the chip containing a plurality of said memory cells formed in memory cell areas of the chip, at least one of the memory cells being sealed from exposure to radiant energy, the sealed memory cell comprising,
a chip substrate (17).
a source (11), and a drain (13) defined within the chip substrate (17) in a memory cell area, a control gate (42) and a floating gate (15,41;15,141) disposed above the substrate (17) in the memory cell area, the floating gate (15) capacitively coupling to the control gate (42) in a coupling area (46) of the memory cell area,
a radiant energy shielding cover (18) in contact with the substrate (17) in a ring (19) completely enclosing the memory cell area, the memory cell area being totally sealed over and around all sides of the memory cell area from radiant energy by the cover (18), and
connecting means (31, 35, 45) defined within the chip substrate electrically to connect the source (11), the drain (13) and the control gate (42) with corresponding source, drain and gate connection terminals (18, 39, 49) outside of the memory cell area, wherein the connecting means (31, 35, 45) includes an electrically conductive channel (45) within the substrate (17) under the ring (19), characterized in that
said control gate (42) is defined within said chip substrate (17),
said floating gate (15) extends over said control gate (42), and
said conductive channel (45) extends from the control gate (42) in the coupling area (46), to said gate connection terminal (49) outside of the memory cell area.

2. A sealed memory cell according to claim 1, wherein the connecting means comprises,
a second electrically conductive channel (35) within the substrate extending from the drain (13) in the memory cell area, under the ring (19), to said drain connection terminal (39) outside of the memory cell area, and
a conductive line (31) electrically contacting the source (11) and the cover (18), the cover (18) being electrically conductive.

3. A sealed memory cell according to claim 2, wherein the first (45) and second (35) conductive channels comprise N-wells, buried N+ implants or buried N+ layers.

4. A sealed memory cell according to claim 1, wherein the floating gate extension (41) above the capacitive coupling area (46) has a polygonal shape.

5. A sealed memory cell according to claim 1, wherein the floating gate extension (141) above the capacitive coupling area (46) has a forked shaped with a plurality of fingers.

6. A sealed memory cell according to claim 1, wherein the cover (18) is composed of metal, polysilicon or monocrystalline silicon.

7. A sealed memory cell according to claim 1, further comprising a thin gate oxide layer (21) disposed over the substrate (17) between the source (11) and the drain (13).

8. A sealed memory cell according to claim 1, wherein the source (11) and said drain (13) are implants spaced apart in a memory cell area of the substrate (17).

9. A sealed memory cell according to claim 1, wherein at least one of the plurality of memory cells formed in memory cell areas of the chip is an EPROM.

10. A sealed memory cell according to claim 1, wherein the connecting means further includes an electrically conductive layer (31) disposed over and contacting the source (11), the conductive layer (31) also contacting a side of the cover (18), the cover (18) also being electrically conductive.

11. A sealed memory cell according to claim 1, wherein the source (11) and drain (13) are defined by arsenic N+ implants.

12. A sealed memory cell according to claim 2, wherein said ring (19) is formed by a ring implant (23) disposed in the substrate beneath the sides of the cover (18), the channels (35, 45) crossing under the ring implant (23) in crossing regions, the ring implant (23) being a P+ implant at least in the crossing regions.

## Patentansprüche

1. Versiegelte Speicherzelle in einem nichtflüchtigen Speicherchip, wobei der Chip mehrere dieser in Speicherzellenbereichen des Chips gebildete Speicherzellen enthält, wobei wenigstens eine der Speicherzellen gegen Strahlungsenergie versiegelt ist und die versiegelte Speicherzelle
ein Chipsubstrat (17),
eine Quelle (11) und einen Ablauf (13), die in dem Chipsubstrat (17) in einem Speicherzellenbereich definiert sind, ein Steuergatter (42) und ein nichtgeerdetes Gatter (15), das oberhalb des Substrates (17) in dem Speicherzellenbereich angeordnet ist, wobei das nichtgeerdete Gatter (15) kapazitiv mit dem Steuergatter (42) in einem Verbindungsbereich (46) des Speicherzellenbereiches verbunden ist,
eine Strahlungsenergieabschirmumhüllung (18) in Kontakt mit dem Substrat (17) in einem den Speicherzellenbereich vollständig einschließenden Ring (19), wobei der Speicherzellenbereich über allen und um alle Seiten des Speicherzellenbereiches gegen Strahlungsenergie durch die Umhüllung (18) versiegelt ist, und
Verbindungseinrichtungen (31, 35, 45), die elektrisch in dem Chipsubstrat definiert sind, um die Quelle (11), den Ablauf (13) und das Steuergatter (42) mit entsprechenden Quellen-, Ablauf- und Gatterverbindungsendanschlüssen (18, 39, 49) außerhalb des Speicherzellenbereiches zu verbindung, wobei die Verbindungseinrichtungen (31, 35, 45) einen elektrisch leitenden Kanal (45) in dem Substrat (17) unter dem Ring (19) einschließen, umfaßt,
**dadurch gekennzeichnet**, daß das Steuergatter (42) in dem Chipsubstrat (17) definiert ist, sich das nichtgeerdete Gatter (15) über das Steuergatter (42) erstreckt und sich der leitende Kanal (45) von dem Steuergatter (42) in dem Verbindungsbereich (46) zu dem Gatterverbindungsendanschluß (49) außerhalb des Speicherzellenbereiches erstreckt.

2. Versiegelte Speicherzelle nach Anspruch 1, bei der die Verbindungseinrichtungen einen zweiten elektrisch leitenden Kanal (35) in dem Substrat, der sich von dem Ablauf (13) in dem Speicherzellenbereich unter dem Ring (19) zu dem Ablaufverbindungsendanschluß (39) außerhalb des Speicherzellenbereiches erstreckt, und eine leitfähige Führung (31), die einen elektrischen Kontakt der Quelle (11) und der Umhüllung (18) erzeugt, umfaßt, wobei die Umhüllung (18) elektrisch leitend ist.

3. Versiegelte Speicherzelle nach Anspruch 1, bei der die ersten (45) und zweiten (35) leitenden Kanäle N-Schächte, unterirdische N+-Einsätze oder unterirdische N+-Schichten umfassen.

4. Versiegelte Speicherzelle nach Anspruch 1, bei der der Fortsatz (41) des nichtgeerdeten Gatters oberhalb des kapazitiven Verbindungsbereiches (46) eine polygonale Form hat.

5. Versiegelte Speicherzelle nach Anspruch 1, bei der der Fortsatz (14) des nichtgeerdeten Gatters oberhalb des kapazitiven Verbindungsbereiches (46) eine Gabelform mit mehreren Fingern hat.

6. Versiegelte Speicherzelle nach Anspruch 1, bei der die Umhüllung (18) aus Metall, Polysilicium oder monokristallinem Silicium besteht.

7. Versiegelte Speicherzelle nach Anspruch 1 weiterhin mit einer dünnen Gatteroxidschicht (21), die über dem Substrat (17) zwischen der Quelle (11) und dem Ablauf (13) angeordnet ist.

8. Versiegelte Speicherzelle nach Anspruch 1, bei der die Quelle (11) und der Ablauf (13) im Abstand voneinander angeordnete Einsätze in einem Speicherzellenbereich des Substrates (17) sind.

9. Versiegelte Speicherzelle nach Anspruch 1, bei der wenigstens eine der mehreren in Speicherzellenbereichen des Chips ausgebildete Speicherzellen ein EPROM ist.

10. Versiegelte Speicherzelle nach Anspruch 1, bei der die Verbindungseinrichtungen weiterhin eine elektrisch leitende Schicht (31), die über und in Kontakt mit der Quelle (11) angeordnet ist, einschließt, wobei die leitende Schicht (31) auch in Kontakt mit einer Seite der Umhüllung (18) steht und die Umhüllung (18) auch elektrisch leitend ist.

11. Versiegelte Speicherzelle nach Anspruch 1, bei der die Quelle (11) und der Ablauf (13) durch Arsen-N + -Einsätze definiert sind.

12. Versiegelte Speicherzelle nach Anspruch 2, bei der der Ring (19) von einem Ringeinsatz (23) gebildet wird, der in dem Substrat unter den Seiten der Umhüllung (18) angeordnet ist, wobei die Kanäle (35, 45) unter dem Ringeinsatz (23) in Kreuzungsbereichen kreuzen und wobei der Ringeinsatz (23) eine P+-Einsatz wenigstens in den Kreuzungsbereichen ist.

## Revendications

1. Cellule de mémoire scellée, dans une puce électronique de mémoire non volatile, la puce comprenant une pluralité desdites cellules de mémoire, constituées en aires de cellules de mémoire de puce, au moins l'une des cellules de mémoire étant scellée pour l'isoler de l'énergie rayonnante, la cellule de mémoire scellée comprenant,
un substrat de puce (17),
une source (11) et un drain (13), définis à l'intérieur du substrat de puce (17), dans une aire de cellule de mémoire, une grille de commande (42), et une grille flottante (15), disposée au-dessus du substrat (17), dans l'aire de cellule de mémoire, la grille flottante (15) assurant une liaison capacitive à la grille de commande (42), dans une aire de couplage (46) de l'aire de cellule de mémoire,
un couvercle de blindage d'énergie rayonnante (18), en contact avec le substrat (17), dans un anneau (19) enclosant entièrement l'aire de cellule mémoire, l'aire de cellule mémoire étant entièrement scellée au-dessus et sur tous les côtés de l'aire de cellule mémoire, vis-à-vis de l'énergie rayonnante, au moyen du couvercle (18), et
des moyens de liaison (31, 35, 45), définis à l'intérieur du substrat de puce, reliant électriquement la source (11), le drain (13) et la grille de commande (42) à des bornes de liaison de source, drain et grille (18, 39, 49) correspondantes, situées à l'extérieur de l'aire de cellule mémoire, dans laquelle les moyens de liaison (31, 35, 45) comprennent un canal conducteur de l'électricite (45), à l'intérieur du substrat (17), sous l'anneau (19),
caractérisée en ce que ladite grille de commande (42) est définie à l'intérieur dudit substrat de puce (17), ladite grille flottante (15) s'étend sur ladite grille de commande (42) et ledit canal conducteur (45) s'étend depuis la grille de commande (42), dans l'aire de couplage (46), jusqu'à ladite borne de liaison (49), située à l'extérieur de l'aire de cellule de mémoire.

2. Cellule de mémoire scellée selon la revendication 1, dans laquelle les moyens de liaison comprennent,
un deuxième canal conducteur de l'électricité (35), à l'intérieur du substrat et s'étendant du drain (13), dans l'aire de cellule de mémoire, sous l'anneau (19), jusqu'à ladite borne de liaison de drain (39), à l'extérieur de l'aire de cellule de mémoire, et
une ligne conductrice (31), assurant la mise en contact électrique de la source (11) et du couvercle (18), le couvercle (18) étant conducteur de l'électricité.

3. Cellule de mémoire scellée selon la revendication 2, dans laquelle les premier (45) et deuxième (35) canaux conducteurs de l'électricité comprennent des puits N, des implants N⁺ enfouis ou des couches N⁺ enfouies.

4. Cellule de mémoire scellée selon la revendication 1, dans laquelle ladite extension de grille flottante (41) située au-dessus de l'aire de couplage capacitif (46) est de forme polygonale.

5. Cellule de mémoire scellée selon la revendication 1, dans laquelle ladite extension de grille flottante (141) située au-dessus de l'aire de couplage capacitif (46) est de forme fourchue, avec une pluralité de doigts.

6. Cellule de mémoire scellée selon la revendication 1, dans laquelle le couvercle (18) est en métal, silicium polycristallin, ou silicium monocristallin.

7. Cellule de mémoire scellée selon la revendication 1, comprenant en outre une mince couche d'oxyde de grille (21), disposée sur le substrat (17), entre la source (11) et le drain (13).

8. Cellule de mémoire scellée selon la revendication 1, dans laquelle la source (11) et ledit drain (13) sont des implants, espacés l'un de l'autre, dans une aire de cellule de mémoire du substrat (17).

9. Cellule de mémoire scellée selon la revendication 1, dans laquelle au moins l'une parmi la pluralité de cellules de mémoire formées dans l'aire de cellule de mémoire de la puce est une EPROM.

10. Cellule de mémoire scellée selon la revendication 1, dans laquelle les moyens de liaison comprennent en outre une couche conductrice de l'électricité (31), disposée sur, et placée en contact avec, la source (11), la couche conductrice (31) étant également en contact avec une face du couvercle (18), le couvercle (18) étant également conducteur de l'électricité.

11. Cellule de mémoire scellée selon la revendication 1, dans laquelle la source (11) et le drain (13) sont définis par des implants N⁺ d'arsenic.

12. Cellule de mémoire scellée selon la revendication 2, dans laquelle ledit anneau (19) est formé par un implant annulaire (23), disposé dans le substrat, sous les faces du couvercle (18), les canaux (35, 45) croisant sous l'implant annulaire (23), dans les aires de croisement, l'implant annulaire (23) étant un implant P⁺, au moins dans les zones de croisement.
